Europäisches Patentamt

European Patent Office

Office européen des brevets

(19)

(11) **EP 0 421 746 B1**

(12) **EUROPEAN PATENT SPECIFICATION**

(45) Date of publication and mention
of the grant of the patent:
**02.04.1997 Bulletin 1997/14**

(51) Int Cl.⁶: **G03F 7/20**

(21) Application number: **90310798.5**

(22) Date of filing: **03.10.1990**

(54) **Exposure apparatus**

Belichtungsvorrichtung

Appareil d'exposition

(84) Designated Contracting States:
**DE FR GB IT NL**

(30) Priority: **03.10.1989 JP 257075/89**
**03.10.1989 JP 257076/89**

(43) Date of publication of application:
**10.04.1991 Bulletin 1991/15**

(73) Proprietor: **CANON KABUSHIKI KAISHA**
**Tokyo (JP)**

(72) Inventors:
• **Watanabe, Yutaka, c/o Canon Kabushiki Kaisha**
**Tokyo (JP)**
• **Ebinuma, Ryuichi, c/o Canon Kabushiki Kaisha**
**Tokyo (JP)**
• **Mizusawa, Nobutoshi,**
**c/o Canon Kabushiki Kaisha**
**Tokyo (JP)**
• **Uzawa, Shunichi, c/o Canon Kabushiki Kaisha**
**Tokyo (JP)**

• **Kariya, Takao, c/o Canon Kabushiki Kaisha**
**Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 083 394**      **EP-A- 0 359 370**
**GB-A- 2 126 740**      **JP-A- 1 243 519**

• **PATENT ABSTRACTS OF JAPAN vol. 9, no. 118**
**(E-316)(1841) 23 May 1985 & JP-A-60 007 722**
• **PATENT ABSTRACTS OF JAPAN vol. 5, no. 88**
**(P-65)(760) 9 June 1981 & JP-A-56 033 633**
• **PATENT ABSTRACTS OF JAPAN vol. 12, no. 63**
**(E-585)(2910) 25 February 1988 & JP-A-62 204**
**527**
• **PATENT ABSTRACTS OF JAPAN vol. 5, no. 179**
**(E-82)(851) 17 November 1981 & JP-A-56 104 438**

## Description

This invention relates to an exposure apparatus for lithographically transferring an image of an original such as a mask onto a workpiece to be exposed, such as a wafer, at high precision.

Recently, the degree of integration of a semiconductor integrated circuit is increasing more and more, and as for an exposure apparatus (aligner) for manufacture of the same, one having higher transfer precision is required. As an example, for an integrated circuit of 256 megabit DRAM, an exposure apparatus capable of printing a pattern of a linewidth of 0.25 micron order is necessary.

As an exposure apparatus for such ultra-fine pattern printing, a proximity exposure apparatus which uses synchrotron orbit radiation (SOR X-rays) has been proposed.

Since the SOR light comprises a sheet-like beam which is uniform in the horizontal direction, the following methods have been proposed to allow exposure of a surface area:

(1) Scan exposure method in which a mask and a wafer are moved vertically so that their surfaces are scanned with X-rays of sheet beam shape, elongated horizontally;
(2) Scan mirror exposure method in which X-rays of sheet beam shape is reflected by a swinging mirror so as to scan a mask and a wafer vertically; and
(3) Simultaneous exposure method in which X-rays of sheet beam shape elongated horizontally is divergently reflected, with respect to the vertical direction, by means of an X-ray mirror having a reflection surface machined into a convex shape, so that the X-rays are projected simultaneously to the whole exposure zone.

An example of X-ray exposure apparatus according to such simultaneous exposure method, has been proposed in Japanese Laid-Open Patent Application, Laid-Open No. 1-243519.

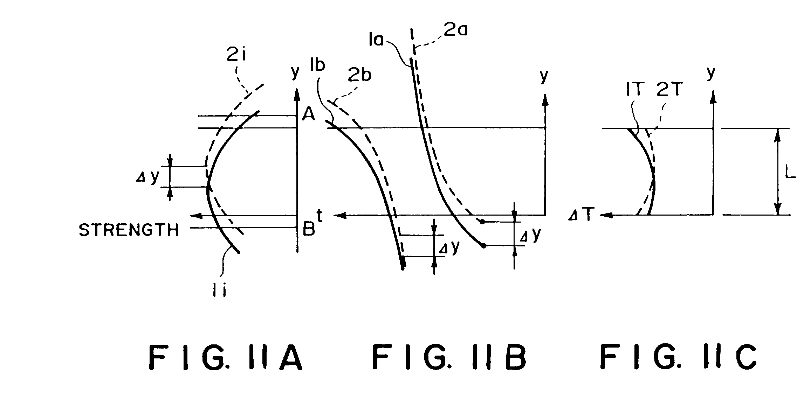

In this type of X-ray exposure apparatus, the X-rays (light to be used for the exposure) has a uniform intensity (illuminance) in respect to the horizontal direction (hereinafter "x-axis direction"). However, with regard to the vertical direction (hereinafter "y-axis direction"), there is non-uniformness in intensity such as depicted by an illuminance distribution curve 1i in Figure 11A, for example, wherein the intensity is high at the middle portion and it decreases with spacing therefrom upwardly and downwardly (y-axis direction). In the aforementioned Japanese Patent Application, two blocking plates each having a rectangular opening (shutter aperture) are used and their moving speeds in the y-axis direction are controlled independently of each other, such as depicted by profiles la and 1b in Figure to thereby control the amount of exposure at each portion of the exposure zone in the manner as depicted by a solid line 1T in Figure 11C. More specifically, with regard to each portion in the y-axis direction, the time from start of transmission of the exposure light (X-rays) responsive to the passage of a leading edge of the aperture of a first blocking plate till the interception of the exposure light responsive to the passage of a trailing edge of the aperture of a second blocking plate, is controlled so as to attain correct and uniform exposure on the whole exposure zone. In this case, the control of the exposure amount is based on the X-ray intensity distribution curve (hereinafter "profile") 1i in respect to the y-axis direction, such as depicted in Figure 11A, as measured in the exposure zone.

As a result of investigations having been made in relation to this type of X-ray exposure apparatus, for further enhancement of the transfer precision, the inventors of the subject application have found that a change in the relative position of the exposure zone and the X-ray flux has a non-negligible effect on the transfer precision.

For example, if the X-ray flux displaces by $\Delta y$ and thus the profile displaces by $\Delta y$, from the solid line position (profile 1i) to the broken line position (profile 2i) in Figure 11A, then the X-ray intensity I at the position y changes by $\Delta y(dI/dy)$. Accordingly, in order to hold the change in intensity I not greater than 0.1 %, the following relation should be satisfied:

$$\Delta y < I/10000 \cdot 1/(dI/dy) = 1/1000 \cdot 1/[(dI/I)/dy]$$

More particularly, assuming now that the field angle dimension of the exposure zone in the y-axis direction is 30 mm, that the profile 1i as depicted by the solid line in Figure 11A is represented by a quadratic function which is vertically symmetrical with respect to the center line and that the lowest intensity is 80 % of the highest intensity, then the following relation is obtained:

$$\Delta y < 1/1000 \cdot 1/(0.4/15) \fallingdotseq 0.04 \text{ mm}$$

Thus, in order to hold the non-uniformness in X-ray intensity not greater than 0.1 %, the relative positional change $\Delta y$ of the X-ray flux with respect to the exposure zone has to be held not greater than 40 microns.

Also, in the proximity exposure method, a change in the angle of incidence of illumination light causes deterioration of the registration precision. If, for example, the proximity gap G between a mask and a wafer is 50 microns, then in order that the registration error $\Delta\delta$ due to the change in the angle of incidence is held not greater than 0.002 micron, the change $\Delta\theta$ in the angle of incidence should satisfy the following relation:

$$\Delta\theta = \Delta\delta/G < 0.002/50 = 4 \times 10^{-5} \text{ rad}$$

Namely, it should be not greater than $4 \times 10^{-5}$ rad.

Also, where the illumination light has a divergent angle, the angle of incidence of the X-rays to the exposure zone changes with the relative positional change $\Delta y$. If the interval between the point of divergence (e.g. the position of incidence of the X-rays upon the X-ray diverging convex mirror) and the surface area to be exposed is 5m, then the quantity $\Delta\theta$ of the change in the angle of incidence is:

$$\Delta\theta = \Delta y/5000$$

Such a change $\Delta\theta$ in the angle of incidence causes a registration error (runout error) $\Delta\delta$ between the mask and the wafer, which can be given by:

$$\Delta\delta = \Delta\theta \cdot G$$

wherein G is the proximity gap between the mask and the wafer. Thus, if the gap G is 50 microns, then in order to hold the registration error $\Delta\delta$ not greater than 0.002 micron, the following relation should be satisfied:

$$\Delta\theta < 0.002/50 = 4 \times 10^{-5} \text{ rad}$$

That is,

$$\Delta y = 5000 \cdot \Delta\theta < 0.2 \text{ mm}$$

Here, predicted factors for the change $\Delta y$ are: one attributable to a change in attitude of the exposure apparatus resulting from movement of a wafer stage (about 200 microns); a relative displacement resulting from a temperature change (about 10 microns); a relative displacement resulting from vibration of the floor (about 2 microns); and the like.

It is accordingly an object of the present invention to provide an exposure apparatus by which a registration error $\Delta\delta$ attributable to a change $\Delta\theta$ in the angle of incidence as described and/or a change $\theta y$ in the relative position as described can be reduced, by which further enhancement of the transfer precision is attained.

The invention provides an exposure apparatus for exposing a substrate with a radiation beam, comprising an irradiating system including a synchrotron orbit radiation (SOR) source device and a mirror unit, for irradiating the substrate with a radiation beam, and an exposure unit, having an exposure zone, for holding the substrate at the exposure zone, wherein the SOR source device, the mirror unit and the exposure unit are mounted on a floor independently of each other, characterized by:

a plurality of detectors disposed at different positions outside the exposure zone, for detecting the radiation beam from the irradiating system, and for producing output signals; signal processing means responsive to the output signals from said detectors, for detecting a change in relative position of the exposure zone of the exposure unit and the radiation beam from the mirror unit; and exposure control means for correcting the exposure conditions in response to a detected change in relative position of the exposure zone and the beam, said exposure control means including at least one of: first control means for adjusting an exposure time distribution of the exposure unit, second control means for adjusting the positional attitude of a shutter unit within the exposure unit, third control means for adjusting the positional attitude of a main body of the exposure unit relative to the floor, fourth control means for adjusting the positional attitude of the mirror unit, and fifth control means for adjusting an electron orbit of the SOR source device.

In the above described structure, illuminance detectors are disposed at least at two points inside the exposure light flux having non-uniformness in intensity. As a result, for all the detectors, the change in intensity of the exposure light can be detected as an illuminance change component of the same proportion. However, for all the detectors, the change in the relative position of the exposure light flux and the exposure zone is detected as an illuminance change component of different proportions. Thus, by discriminating these components, it is possible to detect the change in intensity of the exposure light as well as the change in the relative position of the exposure light flux and the exposure zone.

Further, since each detector is disposed outside the exposure zone, it does not interfere with the exposure operation. Thus, it is possible to detect the change in intensity of the exposure light as well as the change in the relative position of the exposure light and the exposure zone, at any desired timing or in the real-time fashion.

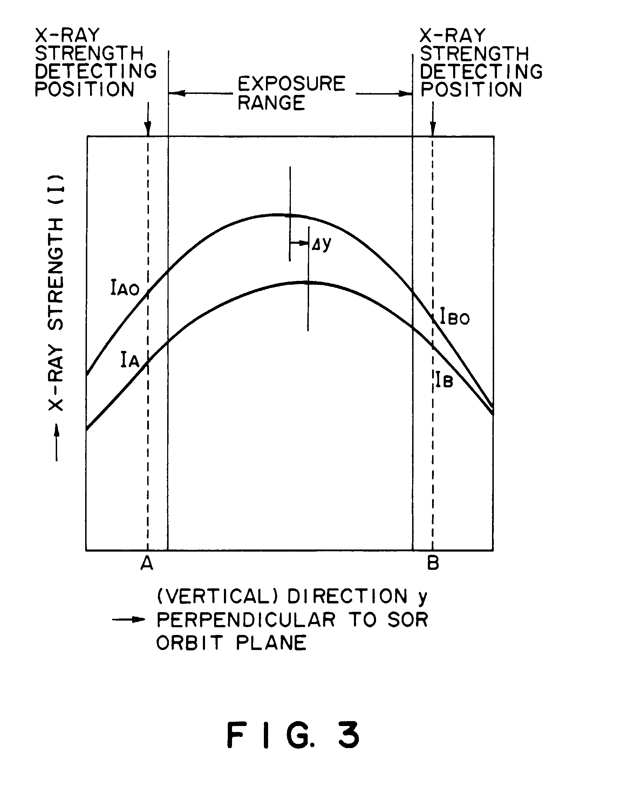

A particular example will now be explained. It is now assumed that, relative to a source of exposure light having a profile such as depicted in Figure 3, first and second illuminance detectors are disposed at points A and B, respectively, and that the outputs of the first and second detectors A and B at time t = 0 are denoted by $I_{A0}$ and $I_{B0}$, respectively. If the outputs of the first and second detectors A and B at time t = t, after the profile has changed by $\Delta y$ and the intensity of the exposure light has changed (attenuated) by f(t), are denoted by $I_A$ and $I_B$, respectively, then, by linear approximation with respect to $\Delta y$, the following relations are provided:

$$I_A = (I_{A0} + k_A \Delta y)f(t) \qquad (1)$$

$$I_B = (I_{B0}+k_B\Delta y)f(t) \qquad (2)$$

wherein

$$k_A = -\left.\frac{dI}{dy}\right|_{y = A}$$

$$k_B = -\left.\frac{dI}{dy}\right|_{y = B}$$

Solving equations (1) and (2), it follows that:

$$f(t) = (1/D)(k_B I_A - k_A I_B) \qquad (3)$$

$$\Delta y = 1/f(t)\cdot(1/D)(I_{A0}I_B - I_{B0}I_A) \qquad (4)$$

wherein,

$$D = I_{A0}k_B - I_{B0}k_A$$

If D = 0, both of f(t) and $\Delta y$ are indeterminate.

The above solutions can be rewritten as follows:

$$f(t) = [1/(\alpha-\beta)](\alpha i_A - \beta i_B) \qquad (5)$$

$$\Delta y = 1/f(t)\cdot[\alpha\beta/(\alpha-\beta)](i_B - i_A) \qquad (6)$$

wherein

$\alpha = I_{A0}/k_A$, $\beta = I_{B0}/k_B$, $i_A = I_A/I_{A0}$ and $i_B = I_B/I_{B0}$. From this, it is seen that the attenuation f(t) attributable to the time of the exposure light flux can be detected with weighted mean, while the change $\Delta y$ in the relative position of the exposure light flux and the exposure zone can be detected as a difference.

In accordance with this aspect of the present invention, as described, it is possible to detect a change in intensity of the exposure light as well as a change in relative position of the exposure light flux and the exposure zone, both at a desired time.

Thus, by adjusting the exposure time in accordance with the change in intensity of the exposure light, it is possible to control the amount of exposure in the real-time fashion and, therefore, it is possible to avoid degradation of transfer precision attributable to a change in exposure amount resulting from a change in intensity of the exposure light.

Further, by using a detection output related to the relative positional change between the exposure light flux and the exposure zone, a light blocking plate drive table for memorization of the state of drive of the shutter blocking plate may be shifted, the attitude of the shutter unit may be adjusted, the attitude of the main body of the exposure apparatus may be adjusted, the attitude of the X-ray mirror may be adjusted, or the electron orbit in the SOR device may be adjusted, for corrective control of the exposure condition on the exposure zone. By doing so, the state of exposure can be held optimum, continuously, and as a result further enhancement of the transfer precision is attainable.

Also, the frequency of profile measurement in the exposure zone may be decreased to improve the throughput of the apparatus.

One embodiment of the invention includes exposure amount controlling means adapted to set an exposure time distribution corresponding to non-uniformness of illumination light in a one-dimensional direction, so as to provide an uniform exposure amount over an exposure zone; and positional reference controlling means operable to shift a positional reference for said exposure amount controlling means, in the one-dimensional direction, with respect to a frame of said exposure apparatus. An exposure apparatus with a controllable exposure time distribution is described for example in EP-A-0359370 (not published at the present priority date) and in JP-A-1 243 519.

Said exposure amount controlling means may include shutter means having a light blocking plate, and driving means for driving said light blocking plate in accordance with a drive curve corresponding to the non-uniformness of intensity, while said positional reference controlling means is operable to shift a reference of the drive curve.

In another embodiment, a portion of the shutter means including a light blocking plate is formed into a unit structure, and such shutter unit is moved in the one-dimensional direction relatively to the frame of the exposure apparatus or, alternatively, it is rotationally moved about the optical axis of the illumination light.

The positional reference can be adjusted in accordance with a signal obtained, for example, by detecting a relative change in attitude between the main body of the exposure apparatus, including the frame, and a floor on which an illumination system including a SOR device (exposure light source) is disposed.

In the above-described structure, if the positional reference controlling means shifts the positional reference for the exposure amount controlling means with respect to the frame of the exposure apparatus, then the exposure time distribution of the illumination light in the exposure zone is shifted. Thus, by detecting the relative positional change $\Delta y$ between the illumination light and the exposure zone and then by shifting the positional reference in accordance with a corresponding detection signal to shift the exposure time distribution, it is possible to compensate the non-uniformness in exposure resulting from the positional change $\Delta y$.

Further, in an arrangement where the positional reference is shifted by relatively shifting the main body of the exposure apparatus and the illumination system, there is an additional advantage that the registration error attributable to the positional change $\Delta y$ can be reduced.

Embodiments of the present invention will now be described with reference to the accompanying drawings in which:-

Figure 1 is a schematic and diagrammatic view of an X-ray aligner according to an embodiment of the present invention.

Figure 2 is a schematic representation, illustrating the positional relationship among an illumination light, an exposure zone and X-ray intensity detectors, in the aligner of Figure 1.

Figure 3 is a representation showing an exemplary X-ray profile.

Figure 4 is a representation, for explaining the principle of detecting the deviation between illumination light and an exposure zone, about an optical axis.

Figure 5 is a schematic and diagrammatic view of an X-ray aligner according to another embodiment of the present invention.

Figures 6 - 10 are schematic and diagrammatic views, respectively, showing X-ray aligners according to further embodiments of the present invention.

Figures 11A - 11C are graphs, respectively, for explaining the operation of an aligner of the present invention, wherein Figure 11A shows an illumination intensity distribution (profile), Figure 11B shows a shutter drive curve and Figure 11C shows an exposure time distribution.

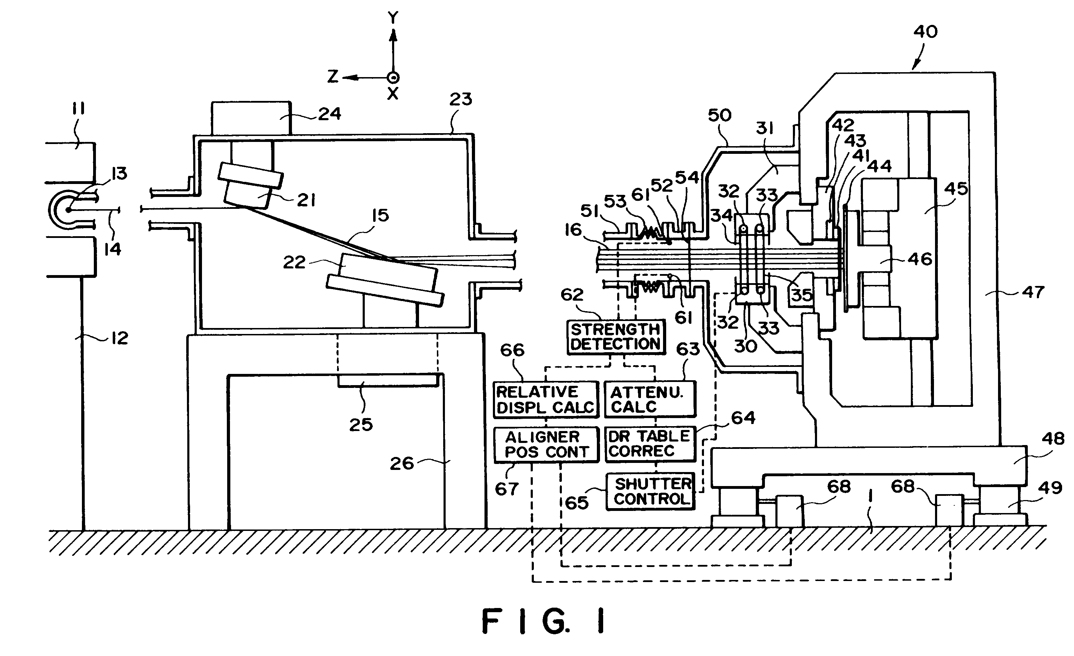

Referring to Figure 1 showing an X-ray aligner according to an embodiment of the present invention, reference numeral 11 denotes a SOR device which is placed on a table 12 and which is adapted to emit X-rays 14 from an emission point 13. Denoted at 21 is a first mirror having a convex-shaped reflection surface for expanding the flux of SOR X-rays 14, having a shape of sheet beam elongated in the x-axis (horizontal) direction, in the y-axis (vertical) direction. Denoted at 22 is a second mirror for reflecting the X-ray flux 15, divergently emanating from the first mirror 21, so that its central axis extends horizontally (z-axis direction). The X-ray flux reflected by the second mirror 22 is inputted to an aligner main body 40 as illumination light 16.

Denoted at 23 is a mirror chamber for surrounding the first mirror 21 and the second mirror 22 with a desired vacuum ambience; at 24 is a first mirror driving device which is used for adjustment of the attitude of the first mirror 21; at 25 is a second mirror driving device which is used for adjustment of the attitude of the second mirror 22; and at 26 is a mirror support.

Denoted at 30 is a shutter unit which comprises a shutter stay 31 and shutter shafts 32 and 33 mounted to the stay 31 as well as shutter films 34 and 35 which are stretched between the shutter shafts 32 - 32 and between the shutter shafts 33 - 33, respectively. The stutter films 34 and 35 are provided by endless steel belts with rectangular openings (not shown) having sides each being longer than the size of the exposure zone with respect to the y-axis direction.

Denoted at 41 is a mask on which a pattern, to be transferred, is formed by using an X-ray non-transmissible material such as gold; at 42 is a movable mask stage for carrying thereon the mask 41; at 43 is a mask chuck for holding the mask 41 on the mask stage 42; at 44 is a wafer onto which an image of the mask 41 is to be transferred; at 45 is a movable wafer stage for carrying thereon the wafer 44 and being movable in the x-axis and y-axis directions; at 46 is a wafer chuck for holding the wafer 44 on the wafer stage 45; at 47 is an aligner frame to which the mask stage 42 and the wafer stage 45, for example, are mounted; at 48 is an aligner base on which the aligner frame 47 is placed; and at 49 are air springs for supporting the aligner base 48 on a floor 1. The aligner base 48 is supported at least at three points by means of at least three air springs 49.

Denoted at 50 is a helium chamber for surrounding the shutter unit 30, the mask 41 placed on the mask stage 42 and the wafer 44 placed on the wafer stage 45, with a desired helium gas ambience. Denoted at 51 and 52 are piping spools for coupling the mirror chamber 23 with the helium chamber 50, i.e., the aligner main body 40, while retaining the respective ambiences. Denoted at 53 is a bellows for flexibly coupling the mirror chamber 23 with the aligner main body 40, and denoted at 54 is a beryllium window effective to transmit the illumination light 16 but to isolate the vacuum ambience in the mirror chamber 23 from the helium ambience in the helium chamber 50. At the mirror chamber 23 side of the beryllium window 54, there are provided X-ray intensity detectors 61 for detection of illumination light, which detectors are disposed above and below the illumination light 16 so as not to block the illumination light 16 directed to the exposure zone.

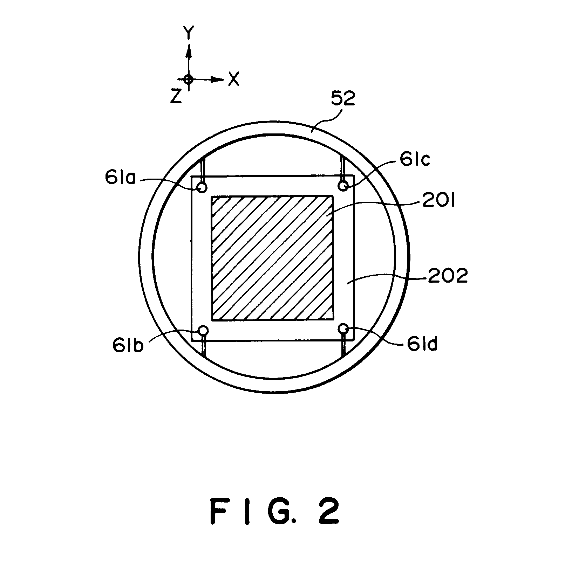

Figure 2 illustrates the positional relationship among the illumination light 16, the exposure zone and the X-ray intensity detectors 61, in the aligner of Figure 1. In Figure 2, denoted at 201 is the exposure zone and denoted at 202 is an X-ray detecting zone. The illumination light 16 illuminates such range that includes both the exposure zone 201 and the X-ray detecting zone 202. As illustrated, at four corners of the region which is outside the exposure zone 201 but which is inside the X-ray detecting zone 202, four X-ray intensity detectors 61 (61a, 61b, 61c and 61d) are provided, each at one corner.

Referring back to Figure 1, denoted at 62 is an X-ray intensity detecting circuit means which is operable to prepare X-ray intensity information on the basis of the outputs of the four X-ray intensity detectors 61. Denoted at 63 is an X-ray intensity attenuation calculating means for executing the computation in accordance with equation (3) or (5), as described, on the basis of the output of the X-ray intensity detecting circuit means 62, to thereby calculate the quantity f(t) of attenuation of the X-ray intensity. Denoted at 64 is a shutter drive table correcting means for correcting the shutter drive table on the basis of the detected X-ray intensity attenuation f(t). Denoted at 65 is a shutter control means for controlling the position or moving speed of the shutter opening at respective time moments, on the basis of the shutter drive table.

Denoted at 66 is a relative positional displacement calculating means for calculating the quantity $\Delta y$ of change in the relative position of the illumination light 16, relative to the aligner main body 40 (i.e., the exposure zone). Denoted at 67 is an aligner position control means which is operable to adjust the quantity of air supply to each air spring on the basis of the detected quantity $\Delta y$ of the relative positional change, to thereby control the attitude of the aligner main body 40 so as to minimize the quantity $\Delta y$ of change in position. Denoted at 68 are air quantity adjusting mechanisms for the air springs.

In the aligner of Figure 1, first, an X-ray illuminomitor (not shown) mounted on a carriage (not shown) is scanningly moved in the exposure zone 202 along the y-axis direction, to prepare an illuminance profile such as shown in Figure 3. At the time of this profile preparation, the X-ray intensity detecting means 62 reads the outputs of the X-ray intensity detectors 61a - 61d and produces information corresponding to the respective detection outputs. The X-ray intensity attenuation calculating means 63 and the relative positional change calculating means 66 calculate an average of the detection outputs of the x-ray intensity detectors 61a and 61c as well as an average of the detection outputs of the detectors 61b and 61d, and memorize them as the above-described values $I_{A0}$ and $I_{B0}$, respectively. It is to be noted here that the outputs of the paired X-ray intensity detectors 61a and 61c as well as the outputs of the paired detectors 61b and 61d are calibrated beforehand so that the outputs of the paired detectors are at the same level when the attitude of the aligner main body 40 is set exactly at its standard state.

During the exposure step, the X-ray intensity detecting means 62 reads the outputs of the X-ray intensity detectors 61a - 61d as desired, such as at a time immediately before the execution of exposure of a first shot area of each wafer, while on the other hand, the X-ray intensity attenuation calculating means 63 and the relative positional change calculating means 66 calculate the attenuation quantity f(t) and the relative positional change quantity $\Delta y$ on the basis of the detected information and the values $I_{A0}$ and $I_{B0}$.

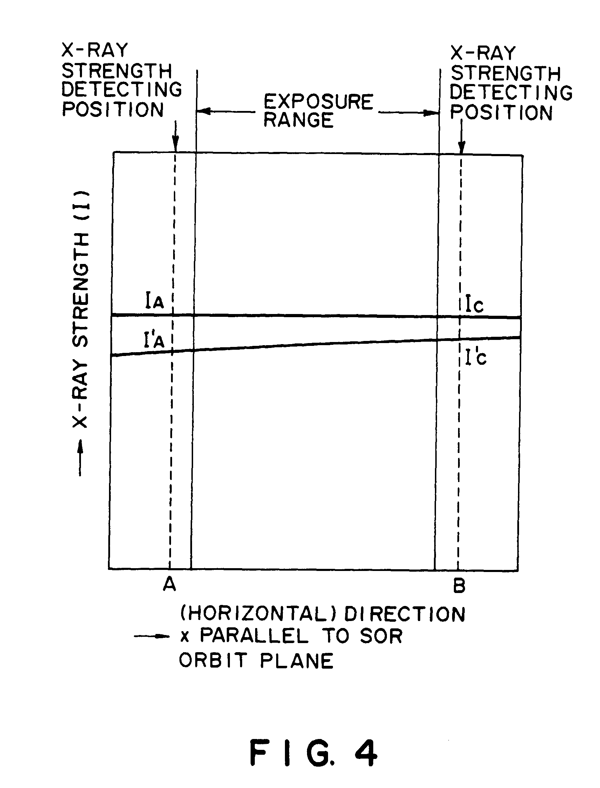

If, on the other hand, the illumination light 16 is rotationally deviated about the z axis (the optical axis of the illumination light 16) relative to the exposure zone 201, as seen in Figure 4 there is a difference between the outputs of the X-ray intensity detectors 61a and 61c. Also, there is a difference between the outputs of the detectors 61b and 61d. Thus, on the basis of a difference between (i) the average of the detection outputs of the detectors 61a and 61b and (ii) the average of the detection outputs of the detectors 61c and 61d, the relative positional change calculating means 66 operates also to calculate the rotational deviation $\Delta wz$ about the z axis.

The shutter drive table correcting means 64 corrects the shutter drive table on the basis of the X-ray intensity attenuation quantity f(t), and the shutter control means 65 controls the exposure time on the basis of the shutter drive table. By this, even if the X-ray intensity changes due to attenuation or the like, it is possible to correct the exposure amount accurately. Further, the aligner position control means 67 adjusts the quantity of air supply to each air spring on the basis of the relative positional change $\Delta y$ and rotational deviation $\Delta wz$, to thereby control the attitude of the aligner main body 40. By this, the relative position of the illumination light 16 and the aligner main body 40, namely, the exposure zone, can be maintained constant and, therefore, the condition for exposure of each wafer can be retained constantly to minimize the transfer error.

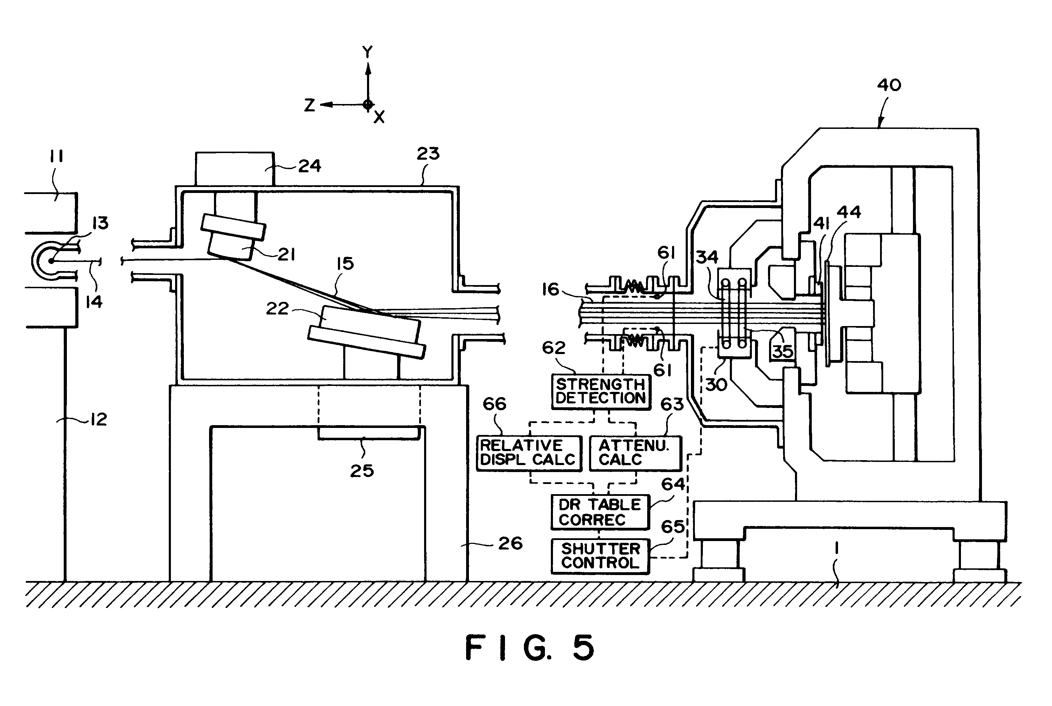

Figure 5 illustrates the structure of an X-ray aligner according to a second embodiment of the present invention. In the aligner of this example, the positional reference for each of the shutter films 34 and 35 is shifted in the y-axis direction by the quantity $\Delta y$ of the change in the relative position of the illumination light, to thereby attain uniformness in the amount of exposure over the exposure zone 201. More specifically, as seen in Figure 11A, a deviation $\Delta y$ of a current profile 2i with respect to a reference profile 1i resulting from the change $\Delta y$ in the relative position is compensated by shifting the respective positional references of the shutter films 34 and 35 in the y-axis direction as seen in Figure 11B, to thereby shift the leading edge la position of the shutter opening to the position at 2a and to shift the trailing edge 1b position to the position at 2b, each by an amount $\Delta y$. As a result, the time from the passage of the leading edge 2a of the shutter opening to the passage of the trailing edge 2b thereof, is shifted to "2T" as seen in Figure 11C, in accordance with the quantity of shift of the profile 2i, whereby uniform exposure amount is attained throughout the exposure zone 201. Since the aligner of Figure 5 is arranged so that the shutter drive table 64 is corrected on the basis of both the X-ray intensity attenuation calculating means 63 and the relative positional change calculating means 66, as compared with the Figure 1 embodiment, it is not necessary to use the aligner position control means 67 or the air supply adjusting means 68, for correction of $\Delta y$. Thus, in such an aligner which is not equipped with these mechanisms, there is an effect of simplification of the structure. However, in the aligner of Figure 5, the runout error is not corrected.

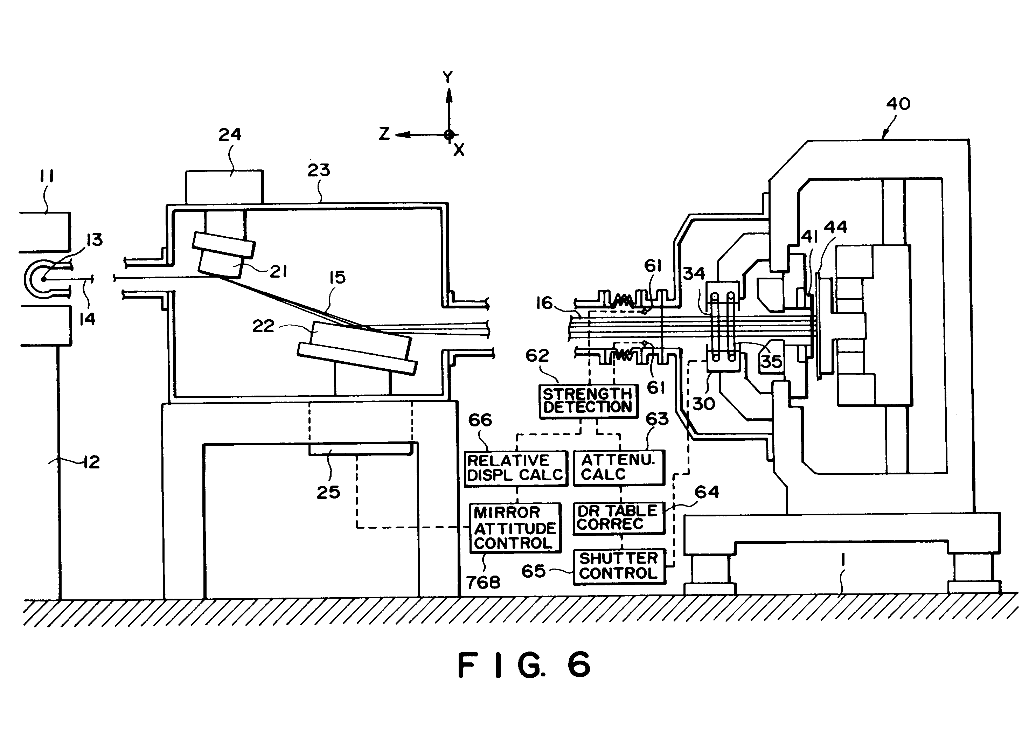

Figure 6 shows the structure of a third embodiment of the present invention. In the aligner of this example, the relative positional displacement $\Delta y$ as well as the rotational deviation $\Delta wz$ are compensated by controlling the attitude of the second mirror 22, to thereby attain uniform exposure. In place of the aligner position control means 67 of the Figure 1 embodiment, the present embodiment is equipped with a mirror attitude control means 768 for controlling the second mirror driving device 25. In this case, there is a possibility of simplification of the structure. However, the runout error is not corrected.

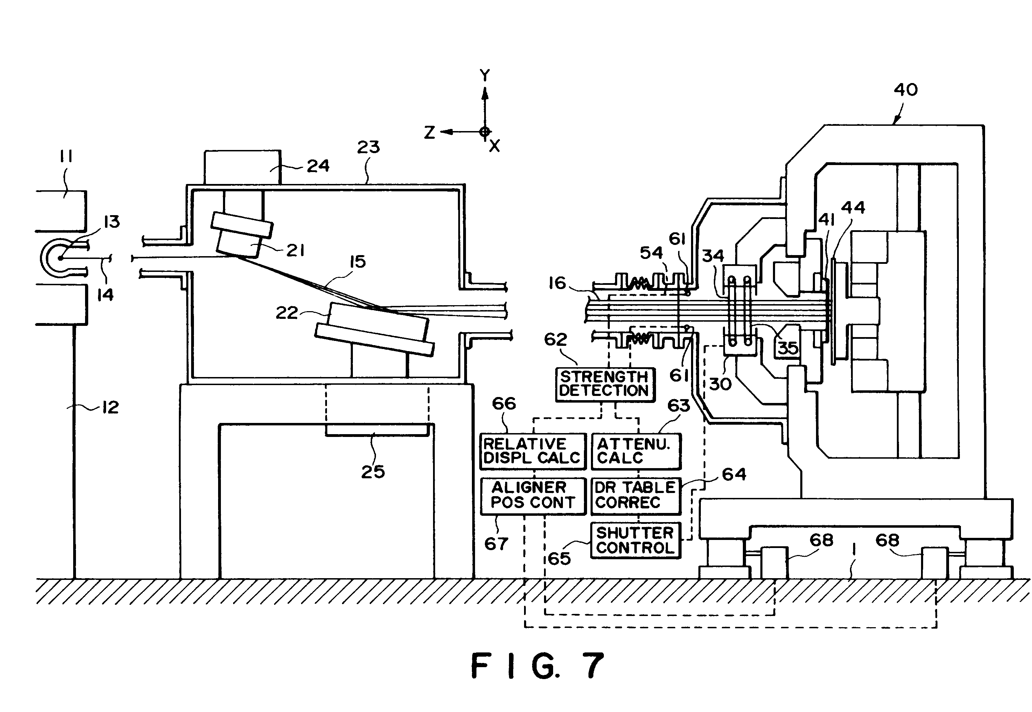

Figure 7 shows a fourth embodiment of the present invention. The aligner of this example has the same structure as the aligner of Figure 1, except for that the X-ray intensity detectors 61 are disposed at the aligner main body 40 side of the beryllium window 54. Since in the aligner of Figure 1 the X-ray intensity detectors 61 are disposed in a ultra-high vacuum, improved lifetime of the detector can be expected. On the other hand, since in the aligner of Figure 7 the visible light is intercepted by the beryllium window 54, improved detection precision of the detector 61 can be expected.

In the aligners of Figures 5 and 6, like the Figure 7 embodiment, the X-ray intensity detectors 61 may be disposed at the aligner main body 40 side of the beryllium window 54.

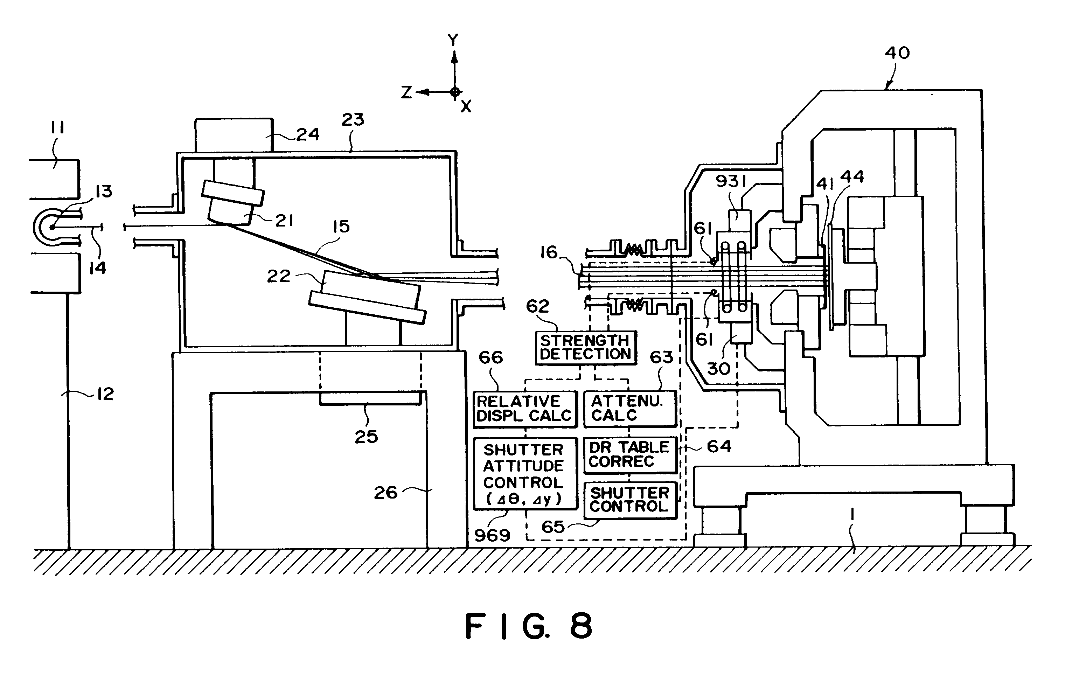

Figure 8 shows a fifth embodiment of the present invention. In the aligner of this example, the shutter unit 30 is mounted to the shutter stay 31 with the intervention of a shutter attitude control device 931, and the X-ray intensity detectors 61 are disposed on the shutter unit 30. Also, in place of the mirror attitude control means 768 of Figure 6, there is provided a shutter attitude control means 969 which is operable to drive the shutter attitude control device 931 on the basis of the relative positional change $\Delta y$ and the rotational deviation $\Delta \theta$ ($\Delta wz$) detected by the relative positional change calculating means 66. In the aligner of Figure 8, the shutter attitude control device 931 causes rotational movement of the shutter unit 30 about the optical axis (z axis) or vertical movement thereof in the y-axis direction, on the basis of the relative positional displacement $\Delta y$ and the rotational deviation $\Delta \theta$. Like the aligners of Figures and 6, this makes it possible to attain uniform exposure in the exposure zone 201.

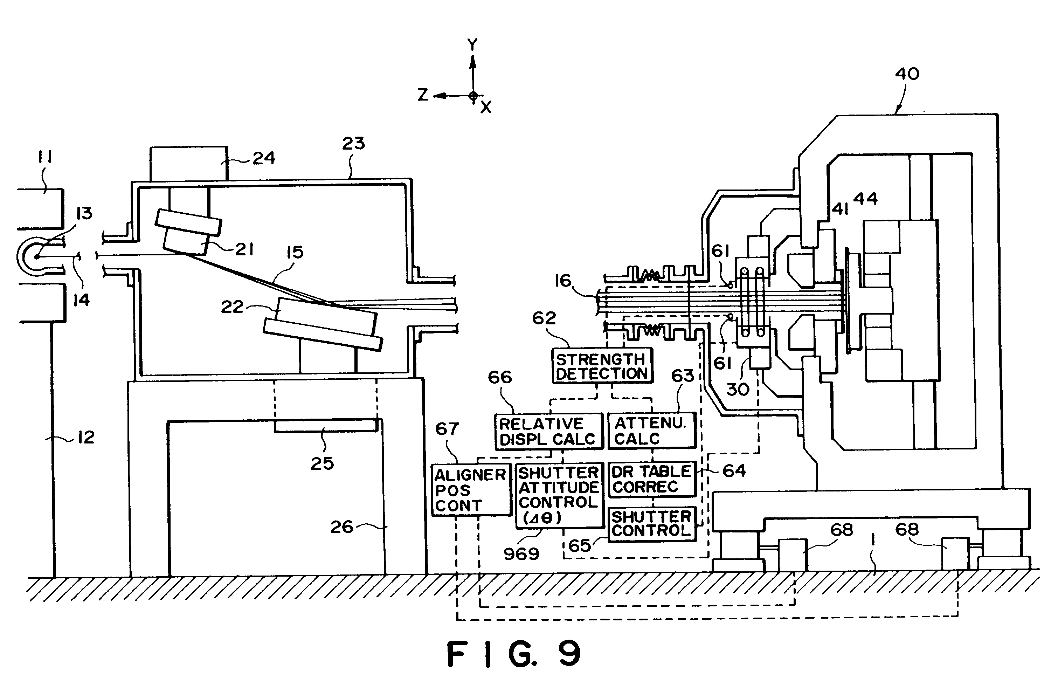

Figure 9 shows a sixth embodiment of the present invention. As compared with the Figure 8 embodiment, the aligner of this example is equipped with an aligner main body control means 67 as well as air quantity adjusting mechanisms 68 for air springs, such that the displacement $\Delta y$ can be compensated by vertically moving the aligner main body 40 while the deviation $\Delta \theta$ can be compensated by rotationally moving the shutter unit 30 about the optical axis. In the aligner of Figure 9, like that of Figure 1, both the attainment of uniform exposure and the prevention of runout error are possible.

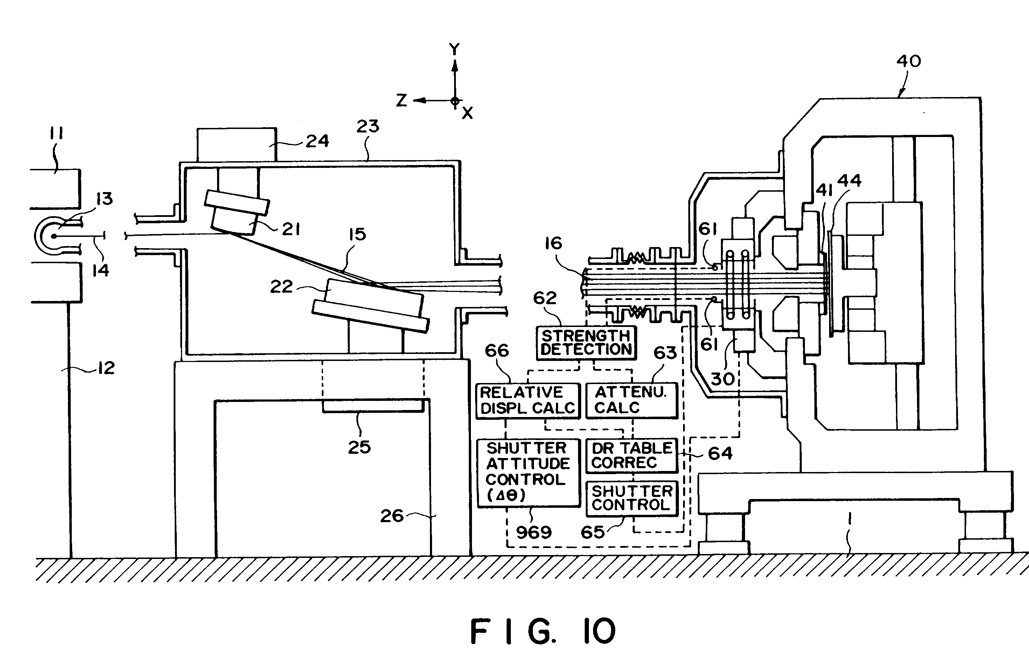

Figure 10 shows a seventh embodiment of the present invention. In the aligner of this example, as compared with the Figure 9 embodiment, the aligner main body control means 67 and the air quantity adjusting mechanisms are omitted, such that like the aligner of Figure 5 the displacement $\Delta y$ is compensated by shifting the positional references of the shutter films 34 and 35. The advantage and disadvantage of the aligner of Figure 10 in comparison with the aligner of Figure 9, are the same as those of the aligner of Figure 5 in comparison with the aligner of Figure 1.

While the invention has been described with reference to the structures disclosed herein, it is not confined to the details set forth and this application is intended to cover such modifications or changes as may come within the scope of the following claims.

## Claims

1. An exposure apparatus for exposing a substrate (44) with a radiation beam, comprising an irradiating system including a synchrotron orbit radiation (SOR) source device (11) and a mirror unit (23), for irradiating the substrate with a radiation beam, and an exposure unit (40), having an exposure zone, for holding the substrate at the exposure zone, wherein the SOR source device (11), the mirror unit (23) and the exposure unit (40) are mounted on a floor (1) independently of each other, characterized by:

   a plurality of detectors (61) disposed at different positions outside the exposure zone, for detecting the radiation beam from the irradiating system, and for producing output signals;
   signal processing means (62, 63, 66) responsive to the output signals from said detectors (61), for detecting a change in relative position of the exposure zone of the exposure unit (40) and the radiation beam from the mirror unit (23); and
   exposure control means for correcting the exposure conditions in response to a detected change in relative position of the exposure zone and the beam, said exposure control means including at least one of:
   first control means (30-35,64,65) for adjusting an exposure time distribution of the exposure unit,
   second control means (969) for adjusting the positional attitude of a shutter unit (30-35) within the exposure unit (40),
   third control means (67,68) for adjusting the positional attitude of a main body of the exposure unit (40) relative to the floor,
   fourth control means (768) for adjusting the positional attitude of the mirror unit (23), and
   fifth control means for adjusting an electron orbit of the SOR source device (11).

**2.** An apparatus according to claim 1, wherein said first control means (30-35,64,65) comprises a shutter (34,35) of said shutter unit (30-35) for alternately blocking and transmitting the radiation beam, driving means (65) for driving said shutter (34,35) on the basis of a data table including stored data for determining at least one of (a) the relative position and (b) the moving speed of said shutter (34,35), and control means (64) for shifting the data in said table on the basis of an output from said signal processing means (62,63,66) representing a change in relative position.

**3.** An apparatus according to claim 1 or claim 2 wherein said detectors (61) are disposed at two points out of the exposure zone, on opposite sides of the plane of the synchrotron radiation.

**4.** An exposure apparatus according to claim 1, wherein said exposure control means comprises:

said first control means (30-35,64,65) adapted to set an exposure time distribution corresponding to non-uniformness of illumination light in a one-dimensional direction, said exposure time distribution being defined relative to a positional reference, so as to provide an uniform exposure amount over an exposure zone; and

positional reference controlling means operable to shift said positional reference in one dimension with respect to a frame of said exposure apparatus, on the basis of an output from said signal processing means (62,63,66) representing a change in relative position.

**5.** An apparatus according to claim 4, wherein said first control means (30-35,64,65) includes said shutter unit (30-35) having a light blocking plate, and driving means (65) for driving said light blocking plate in accordance with a drive curve corresponding to the non-uniformness of intensity, and wherein said positional reference controlling means is operable to shift a reference of the drive curve.

**6.** An apparatus according to claim 4, wherein said first control means (30-35,64,65) includes said shutter unit (30-35) which is movable relatively to a frame of said exposure apparatus, and wherein said positional reference controlling means includes said second control means (969) operable to drive said shutter unit (30-35) in said one dimension.

**7.** An exposure apparatus according to claim 6, wherein said second control means (969) operates to rotationally move said shutter unit (30-35) about an optical axis of the radiation beam.

**8.** An exposure unit for use in a SOR exposure apparatus, the exposure unit including:

a plurality of detectors (61) disposed at different positions outside an exposure zone, for detecting the radiation beam of a SOR device; signal processing means (62, 63, 66) responsive to output signals of said detectors (61) for detecting a change in relative position of the exposure zone and the radiation beam; a wafer stage (45) and mask stage (42) mounted in the exposure zone for exposing a wafer (44) to a mask pattern (41); and exposure control means for correcting exposure conditions in response to a detected change in relative position of the exposure zone and the radiation beam, said exposure control means comprising at least one of: first control means (30-35, 64,65) for adjusting an exposure time distribution of the exposure unit (40), a second control means (969) for adjusting the positional attitude of a shutter unit (30-35) within the exposure unit (40), third control means (67,68) for adjusting the positional attitude of a main body of the exposure unit (40), fourth control means (768) for adjusting the positional attitude of a mirror for directing the radiation beam towards the exposure zone and mounted independently of the exposure unit (40), and fifth control means for adjusting an electron orbit of an SOR source device mounted independently of the exposure unit (40).

**Patentansprüche**

**1.** Belichtungsvorrichtung zur Belichtung eines Substrats (44) mit einem Bestrahlungsstrahl, die ein BestrahlungsSystem aufweist, das eine Synchrotronorbitstrahlungs(SOR)-Quelleneinrichtung (11) und eine Spiegeleinheit (23), um das Substrat mit einem Bestrahlungsstrahl zu bestrahlen, und eine Belichtungseinheit (40) enthält, die eine Belichtungszone hat, um das Substrat in der Belichtungszone zu halten, wobei die SOR-Quelleneinrichtung (11), die Spiegeleinheit (23) und die Belichtungseinheit (40) unabhängig voneinander auf einem Boden (1) befestigt sind,
**gekennzeichnet durch**

eine Vielzahl von Detektoren (61), die in verschiedenen Positionen außerhalb der Belichtungszone angeordnet sind, um den Bestrahlungsstrahl aus dem Bestrahlungssystem zu erfassen und um Ausgangssignale zu erzeugen,

eine auf die Ausgangssignale von den Detektoren (61) ansprechende Signalverarbeitungseinrichtung (62, 63, 66),

um eine Änderung in der Relativposition der Belichtungszone der Belichtungseinheit (40) und des Bestrahlungsstrahls aus der Spiegeleinheit (23) zu erfassen, und

eine Belichtungssteuereinrichtung zur Korrektur der Belichtungsbedingungen in Antwort auf eine erfaßte Änderung in der Relativposition der Belichtungszone und des Strahls, wobei die Belichtungssteuereinrichtung mindestens eine der folgenden Einrichtungen enthält,

eine erste Steuereinrichtung (30 - 35, 64, 65) zur Einstellung einer Belichtungszeitverteilung der Belichtungseinheit,

eine zweite Steuereinrichtung (969) zur Einstellung der Positionslage einer Blendeneinheit (30 - 35) innerhalb der Belichtungseinheit (40),

eine dritte Steuereinrichtung (67, 68) zur Einstellung der Positionslage eines Hauptkörpers der Belichtungseinheit (40) relativ zum Boden,

eine vierte Steuereinrichtung (768) zur Einstellung der Positionslage der Spiegeleinheit (23) und

eine fünfte Steuereinrichtung zur Einstellung einer Elektronenbahn der SOR-Quelleneinrichtung (11).

2. Vorrichtung gemäß Anspruch 1, bei welcher die erste Steuereinrichtung (30 - 35, 64, 65) eine Blende (34, 35) der Blendeneinheit (30 - 35) zum abwechselnden Unterbrechen und Durchlassen des Bestrahlungsstrahls, eine Antriebseinrichtung (65) zum Antrieb der Blende (34, 35) auf der Basis einer Datentabelle, die gespeicherte Daten enthält, um mindestens (a) die Relativposition und/oder (b) die Bewegungsgeschwindigkeit der Blende (34, 35) zu bestimmen, und eine Steuereinrichtung (64) zur Verstellung der Daten in der Tabelle auf der Basis eines Ausgangswerts aus der Signalverarbeitungseinrichtung (62, 63, 66) aufweist, der eine Änderung in der Relativposition repräsentiert.

3. Vorrichtung gemäß Anspruch 1 oder Anspruch 2, bei welcher die Detektoren (61) an zwei Punkten außerhalb der Belichtungszone, auf entgegengesetzten Seiten der Ebene der Synchrotronstrahlung angeordnet sind.

4. Belichtungsvorrichtung gemäß Anspruch 1, bei welcher die Belichtungssteuereinrichtung aufweist,

die erste Steuereinrichtung (30 - 35, 64, 65), die dazu angepaßt ist, eine Belichtungszeitverteilung entsprechend einer Ungleichmäßigkeit des Beleuchtungslichts in einer eindimensionalen Richtung einzustellen, wobei die Belichtungszeitverteilung relativ zu einem Positionsbezugspunkt definiert wird, um über eine Belichtungszone hinweg einen einheitlichen Betrag der Belichtung zu schaffen, und

eine Positionsbezugspunkt-Steuereinrichtung, die betätigbar ist, um den Positionsbezugspunkt auf der Basis eines Ausgangswerts aus der Signalverarbeitungseinrichtung (62, 63, 66), der eine Änderung der Relativposition repräsentiert, mit Bezug auf einen Rahmen der Belichtungsvorrichtung in einer Dimension zu verschieben.

5. Vorrichtung gemäß Anspruch 4, bei welcher die erste Steuereinrichtung (30 - 35, 64, 65) die Blendeneinheit (30-35), die eine Lichtunterbrechungsplatte hat, und eine Antriebseinrichtung (65) enthält, um die Lichtunterbrechungsplatte in Übereinstimmung mit einer Antriebskurve entsprechend der Ungleichmäßigkeit der Intensität anzutreiben, und bei welcher die Positionsbezugspunkt-Steuereinrichtung betätigbar ist, um einen Bezugspunkt der Antriebskurve zu verschieben.

6. Vorrichtung gemäß Anspruch 4, bei welcher die erste Steuereinrichtung (30 - 35, 64, 65) die Blendeneinheit (30 - 35) enthält, welche relativ zu einem Rahmen der Belichtungsvorrichtung beweglich ist, und bei welcher die Positionsbezugspunkt-Steuereinrichtung die zweite Steuereinrichtung (969) enthält, die betätigbar ist, um die Blendeneinheit (30 - 35) in der einen Dimension anzutreiben.

7. Belichtungsvorrichtung gemäß Anspruch 6, bei welcher die zweite Steuereinrichtung (969) betätigt wird, um die Blendeneinheit (30 - 35) auf drehende Weise um eine optische Achse des Bestrahlungsstrahls zu bewegen.

8. Belichtungseinheit zum Gebrauch in einer SOR-Belichtungsvorrichtung, wobei die Belichtungseinheit enthält, eine Vielzahl von Detektoren (61), die in verschiedenen Positionen außerhalb der Belichtungszone angeordnet sind, um den Bestrahlungsstrahl einer SOR-Einrichtung zu erfassen,

eine auf die Ausgangssignale der Detektoren (61) ansprechende Signalverarbeitungseinrichtung (62, 63, 66), um eine Änderung in der Relativposition der Belichtungszone und des Bestrahlungsstrahls zu erfassen,

einen Wafertisch (45) und einen Maskentisch (42), die in der Belichtungszone angebracht sind, um einen Wafer (44) mit einem Maskenmuster (41) zu belichten, und

eine Belichtungssteuereinrichtung zur Korrektur der Belichtungsbedingungen in Antwort auf eine erfaßte Änderung in der Relativposition der Belichtungszone und des Bestrahlungsstrahls,

wobei die Belichtungssteuereinrichtung mindestens eine der folgenden Einrichtungen enthält, eine erste Steuereinrichtung (30 - 35, 64, 65) zur Einstellung einer Belichtungszeitverteilung der Belichtungseinheit (40),

eine zweite Steuereinrichtung (969) zur Einstellung der Positionslage einer Blendeneinheit (30 - 35) innerhalb der Belichtungseinheit (40), eine dritte Steuereinrichtung (67, 68) zur Einstellung der Positionslage eines Hauptkörpers der Belichtungseinheit (40),

eine vierte Steuereinrichtung (768) zur Einstellung der Positionslage eines Spiegels, der zum Ausrichten des Bestrahlungsstrahls in Richtung auf die Belichtungszone dient und unabhängig von der Belichtungseinheit (40) befestigt ist, und

eine fünfte Steuereinrichtung zur Einstellung einer Elektronenbahn der SOR-Quelleneinrichtung, die unabhängig von der Belichtungseinheit (40) befestigt ist.

**Revendications**

1. Appareil d'exposition pour exposer un substrat (44) à un faisceau de rayonnement, comportant un système d'irradiation comprenant un dispositif (11) à source de rayonnement orbital de synchrotron et une unité (23) à miroirs, pour irradier le substrat avec un faisceau de rayonnement, et une unité d'exposition (40), ayant une zone d'exposition, destinée à maintenir le substrat dans la zone d'exposition, le dispositif (11) à source (SOR), l'unité à miroirs (23) et l'unité d'exposition (40) étant montées sur un sol (1), indépendamment, les uns des autres, caractérisé par :

plusieurs détecteurs (61) disposés dans des positions différentes à l'extérieur de la zone d'exposition, pour détecter le faisceau de rayonnement provenant du système d'irradiation, et pour produire des signaux de sortie ; des moyens (62, 63, 66) de traitement de signaux sensibles aux signaux de sortie provenant desdits détecteurs (61) pour détecter une variation de position relative de la zone d'exposition de l'unité (40) d'exposition et du faisceau de rayonnement provenant de l'unité à miroirs (23) ; et

des moyens de commande d'exposition destinés à corriger les conditions d'exposition en réponse à une variation détectée de position relative de la zone d'exposition et du faisceau, lesdits moyens de commande d'exposition comprenant au moins l'un :

de premiers moyens de commande (30-35, 64, 65) destinés à ajuster une distribution de temps d'exposition de l'unité d'exposition, de deuxièmes moyens de commande (969) destinés à ajuster l'attitude de position d'une unité à obturateur (30-35) dans l'unité d'exposition (40),

de troisièmes moyens de commande (67, 68) destinés à ajuster l'attitude de position d'un corps principal de l'unité d'exposition (40) par rapport au sol,

de quatrièmes moyens de commande (768) destinés à ajuster l'attitude de position de l'unité à miroirs (23), et

de cinquièmes moyens de commande destinés à ajuster une orbite d'électrons du dispositif (11) à source (SOR).

2. Appareil selon la revendication 1, dans lequel lesdits premiers moyens de commande (30-35, 64, 65) comprennent un obturateur (34, 35) de ladite unité à obturateur (30-35) pour alternativement arrêter et transmettre le faisceau de rayonnement, des moyens d'entraînement (65) destinés à entraîner ledit obturateur (34, 35) sur la base d'une table de données comprenant des données stockées pour déterminer au moins l'une (a) de la position relative et (b) de la vitesse de déplacement dudit obturateur (34, 35), et des moyens de commande (64) destinés à décaler les données dans ladite table sur la base d'un signal de sortie desdits moyens (62, 63, 66) de traitement de signaux, représentant une variation de position relative.

3. Appareil selon la revendication 1 ou la revendication 2, dans lequel lesdits détecteurs (61) sont disposés en deux points en dehors de la zone d'exposition, sur des côtés opposés du plan du rayonnement de synchroton.

4. Appareil d'exposition selon la revendication 1, dans lequel lesdits moyens de commande d'exposition comprennent :

lesdits premiers moyens de commande (30-35, 64, 65) destinés à établir une distribution de temps d'exposition correspondant à un manque d'uniformité d'une lumière d'illumination dans une direction à une dimension, ladite distribution de temps d'exposition étant définie par rapport à une référence de position, afin de produire une quantité d'exposition uniforme sur une zone d'exposition ; et

des moyens de commande de référence de position pouvant agir pour décaler ladite référence de position dans une première dimension par rapport à un bâti dudit appareil d'exposition, sur la base d'un signal de sortie desdits moyens (62, 63, 66) de traitement de signaux, représentant une variation de position relative.

5. Appareil selon la revendication 4, dans lequel lesdits premiers moyens de commande (30, 35, 64, 65) comprennent ladite unité à obturateur (30-35) ayant une plaque d'arrêt de la lumière, et des moyens d'entraînement (65) destinés à entraîner ladite plaque d'arrêt de la lumière en fonction d'une courbe d'entraînement correspondant au manque d'uniformité de l'intensité, et dans lequel lesdits moyens de commande de référence de position peuvent agir de façon à décaler une référence de ladite courbe d'entraînement.

6. Appareil selon la revendication 4, dans lequel lesdits premiers moyens de commande (30-35, 64, 65) comprennent ladite unité à obturateur (30-35) qui est mobile par rapport à un bâti dudit appareil d'exposition, dans lequel lesdits moyens de commande de référence de position comprennent lesdits deuxièmes moyens de commande (969) pouvant agir pour entraîner ladite unité à obturateur (30-35) dans ladite première dimension.

7. Appareil d'exposition selon la revendication 6, dans lequel lesdits deuxièmes moyens de commande (969) agissent pour faire tourner ladite unité à obturateur (30-35) autour d'un axe optique du faisceau de rayonnement.

8. Unité d'exposition à utiliser dans un appareil d'exposition du type SOR, l'unité d'exposition comprenant :

plusieurs détecteurs (61) disposés dans des positions différentes à l'extérieur d'une zone d'exposition, pour détecter le faisceau de rayonnement d'un dispositif SOR ;
des moyens (62, 63, 66) de traitement de signaux qui, en réponse à des signaux de sortie desdits détecteurs (61), sont destinés à détecter une variation de la position relative de la zone d'exposition et du faisceau de rayonnement ;
une platine (45) pour tranche et une platine (42) pour masque montées dans la zone d'exposition pour exposer une tranche (44) à un motif (41) d'un masque ; et
des moyens de commande d'exposition destinés à corriger des conditions d'exposition en réponse à une variation détectée de la position relative de la zone d'exposition et du faisceau de rayonnement,
lesdits moyens de commande d'exposition comportant au moins l'un :

de premiers moyens de commande (30-35, 64, 65) destinés à ajuster une distribution de temps d'exposition de l'unité d'exposition (40),
de deuxièmes moyens de commande (969) destinés à ajuster l'attitude de position d'une unité à obturateur (30-35) dans l'unité d'exposition (40),
de troisièmes moyens de commande (67, 68) destinés à ajuster l'attitude de position d'un corps principal de l'unité d'exposition (40),
de quatrièmes moyens de commande (768) destinés à ajuster l'attitude de position d'un miroir destiné à diriger le faisceau de rayonnement vers la zone d'exposition et monté, indépendamment, de l'unité d'exposition (40), et
de cinquièmes moyens de commande destinés à ajuster une orbite d'électrons d'un dispositif à source SOR monté, indépendamment, de l'unité d'exposition (40).

F I G. 1

EP 0 421 746 B1

F I G. 2

EP 0 421 746 B1

F I G. 3

F I G. 4

F I G. 5

EP 0 421 746 B1

F I G. 6

EP 0 421 746 B1

FIG. 7

EP 0 421 746 B1

FIG. 8

40

41 44

931

61

61

30

64

63

ATTENU. CALC

DR TABLE CORREC

SHUTTER CONTROL

STRENGTH DETECTION

62

16

RELATIVE DISPL CALC

SHUTTER ATTITUDE CONTROL (4θ, 4y)

65

969

66

Y

X

Z

23

24

21

22

15

25

26

13

14

11

12

F I G. 9

EP 0 421 746 B1

F I G. 10

EP 0 421 746 B1

FIG. IIA   FIG. IIB   FIG. IIC